Europäisches Patentamt

European Patent Office

Office européen des brevets

(19)

(11) EP 0 599 008 B1

(12) **EUROPÄISCHE PATENTSCHRIFT**

(45) Veröffentlichungstag und Bekanntmachung des Hinweises auf die Patenterteilung:
25.11.1998  Patentblatt 1998/48

(51) Int Cl.⁶: **G01R 23/16**

(21) Anmeldenummer: 93114995.9

(22) Anmeldetag: 17.09.1993

(54) **Verfahren zur Mittelung und Datenverdichtung für Messgeräte**

Procedure for determining the mean value and for compacting data of measuring instruments

Procédé pour déterminer la valeur moyenne et pour rendre plus compacte les données d'instruments de mesure

(84) Benannte Vertragsstaaten:
DE FR GB IT

(30) Priorität: 21.11.1992  DE 4239215

(43) Veröffentlichungstag der Anmeldung:
01.06.1994  Patentblatt 1994/22

(73) Patentinhaber: Wandel & Goltermann GmbH & Co. Elektronische Messtechnik
D-72795 Eningen (DE)

(72) Erfinder: Bohley, Rolf
D-72770 Reutlingen (DE)

(74) Vertreter: Späth, Dieter, Dipl.-Ing.
Klocke - Späth - Neubauer
Patentanwälte,
Kappelstrasse 8
72160 Horb (DE)

(56) Entgegenhaltungen:
DE-A- 3 817 499          US-A- 4 794 324

• PATENT ABSTRACTS OF JAPAN vol. 8, no. 175 (P-294)(1612) 11. August 1984 & JP-A-59 070 970 (NITSUSHIN DENKI)

## Beschreibung

Die Erfindung betrifft ein Verfahren zur Mittelung und Datenverdichtung für Meßgeräte gemäß der Gattung des Anspruchs 1.

Es sind digitale Verfahren zur Meßwertverdichtung und digitalen Mittelung bekannt, die jedoch entweder eine geringe Mittelungswirkung bei Rauschen besitzen oder zu einer unerwünschten Unterdrückung von schmalen, diskreten Signalen führen, beispielsweise bei der Messung des frequenzabhängigen Spektrums mittels eines Spektrumanalysators.

Aus der DE 38 17 499 C1 ist ein Verfahren zum Messen von Funkstörgrößen in einem vorgegebenen Gesamtfrequenzbereich bekannt, bei dem zur Verkürzung der Meßzeit der Gesamtfrequenzbereich in Intervalle unterteilt und in jedem Intervall die während der Messung aufgetretene, maximale Amplitude zusammen mit ihrer Frequenz gespeichert wird. Zusätzlich können auch ein Mittelwert oder ein frequenzabhängig bewerteter Wert in jedem Intervall gespeichert werden. Anschließend erfolgt eine Auswertung der gespeicherten Meßwerte. Bei dem bekannten Verfahren werden bestimmte Meßwerte, nämlich insbesondere die maximalen Amplituden in den Meßintervallen, ermittelt, und anhand dieser Meßwerte wird beurteilt, ob vorgegebene Störkriterien eingehalten oder überschritten werden. Da lediglich für die Beurteilung charakteristische Meßwerte, nämlich insbesondere die Maximalamplituden gespeichert werden, geht ein Großteil von Informationen über das gemessene Funkstörgrößensignal verloren. Des weiteren wird die während der Messung auftretende maximale Amplitude als für die Funkstörgröße charakteristischer Meßwert ausgewählt. Tritt während der Dauer der Messung bei einer bestimmten Frequenz eine besonders hohe Amplitude auf oder wird die übliche Amplitudenhöhe bei dieser Frequenz während der Messung nicht erreicht, wird ein Ausnahmewert als charakteristischer Meßwert gespeichert. Bei den Frequenzen, bei denen ein Ausnahmewert aufgetreten ist, wird anschließend eine bewertende Messung durchgeführt. Das bekannte Verfahren unterliegt daher einem hohen Zufallseinfluß.

Bei einem aus der JP-A 59-70 970 bekannten Verfahren wird für eine beispielsweise 10 Minuten andauernde Messung eine Berechnung, insbesondere eine Fourierentwicklung durchgeführt und Maximum- und Minimumwerte sowie jeweils fünf Meßwerte nahe der Maximum- und Minimumwerte gespeichert. Anschließend wird der Mittelwert der Daten gebildet, um die Zuverlässigkeit der Messung der Amplituden hoher Oberwellen zu verbessern. Dieses Verfahren ist aufwendig in der Durchführung, es erfordert eine aufwendige Berechnung und die Speicherung einer Vielzahl von Meßwerten.

Der Erfindung liegt die Aufgabe zugrunde, ein Verfahren zu schaffen, welches auch für Spektrumanalysatoren einsetzbar ist und einen geringen Informationsverlust bei der Verdichtung und Mittelung aufweist.

Die Lösung dieser Aufgabe erhält man durch die im Anspruch 1 angegebenen Merkmale. Jeder Meßdurchlauf wird in mehrere Meßintervalle unterteilt und jedes Meßintervall wird in mehrere Teilintervalle unterteilt, wobei die Teilintervalle innerhalb eines Meßintervalls numeriert sind und die Nummer eines Teilintervalls als Relativadresse dieses Teilintervalls bezeichnet wird. Innerhalb eines Meßdurchlauf wird eine Verdichtung dadurch erreicht, daß aus jedem Meßintervall nur ein erster und ein zweiter Meßwert sowie ein dritter und ein vierter Wert, die keine Meßwerte sind, für die Weiterverarbeitung benutzt werden. In aufeinanderfolgenden Meßdurchläufen wird ständig eine Meßwertmittelung durchgeführt, wobei erste Meßwerte gleicher Meßintervalle miteinander gemittelt werden und ebenso zweite Meßwerte gleicher Meßintervalle gemittelt werden. Die Mittelwerte werden dann wiederum zur Mittelwertbildung bei weiteren Meßdurchläufen herangezogen, so daß während des Meßverfahrens eine ständig genauer werdende Mittelwertbildung vorgenommen wird.

Besonders vorteilhaft ist es, in jedem Meßdurchlauf die Nummer des Teilintervalls, in dem der Minimalwert aufgetreten ist, als dritten Wert (Relativadresse AMI) und den Meßwert des Teilintervalls mit der im davorliegenden Meßdurchlauf ermittelten Relativadresse AMI als ersten Meßwert zu erfassen. In gleicher Weise ist die Nummer des Teilintervalls, in dem der Maximalwert aufgetreten ist, als vierter Wert (Relativadresse AMA) und der Meßwert des Teilintervalls mit der im davorliegenden Meßdurchlauf ermittelten Relativadresse AMA als zweiter Meßwert zu erfassen.

Da es beim ersten Meßdurchlauf noch keine Relativadressen eines davorliegenden Meßdurchlaufs gibt, wird hier als erster Meßwert der Minimalwert und als zweiter Meßwert der Maximalwert innerhalb eines Meßintervalls benutzt.

Auf diese Weise erhält man bei Rauschsignalen, bei denen Minimalwert und Maximalwert an zufälligen Stellen auftreten, eine wirksame Mittelung, während gleichzeitig die stets an derselben Position auftretenden Nutzsignale (deterministische Signale) genau bestimmt werden können.

Durch das erfindungsgemäße Verfahren wird die Forderung nach einer wirksamen Rauschmittelung und einer korrekten Darstellung schmaler, diskreter Signale gleichzeitig erfüllt. Dies ist besonders vorteilhaft bei einem Einsatz in Spektrum- und Verzerrungsanalysatoren, die in der Nachrichtenmeßtechnik verwendet werden.

Das Mittelungsverfahren wird nachfolgend anhand von in der Zeichnung dargestellten Meßdiagrammen näher erläutert.

Es zeigen:

Figur 1 den Signalverlauf innerhalb eines Meßintervalls während eines ersten Meßdurchlaufs,

Figur 2 den Signalverlauf innerhalb eines Meßintervalls während eines zweiten Meßdurchlaufs,

Figur 3 den Signalverlauf innerhalb eines Meßintervalls während eines dritten Meßdurchlaufs,

Figur 4 den Signalverlauf innerhalb eines Meßintervalls während eines vierten Meßdurchlaufs.

Das Mittelungsverfahren ist für Meßgeräte geeignet, die eine Größe Y in Abhängigkeit von einer Größe X messen. Beispielsweise kann als Größe Y die Amplitude (Spannung) in Abhängigkeit von der Frequenz (Größe X) gemessen werden. Zwischen einem Startwert X-Start und einem Stopwert X-Stop wird der Meßbereich in Meßintervalle unterteilt, wobei während eines Meßdurchlaufs zu jedem Meßintervall wenigstens ein erster Wert MI und ein zweiter Wert MA gemessen wird.

Im dargestellten Ausführungsbeispiel wird jedes Meßintervall nochmals in 16 Teilintervalle (0 bis 15) unterteilt, die somit 16 mögliche Positionen für die Messungen in einem Meßintervall darstellen.

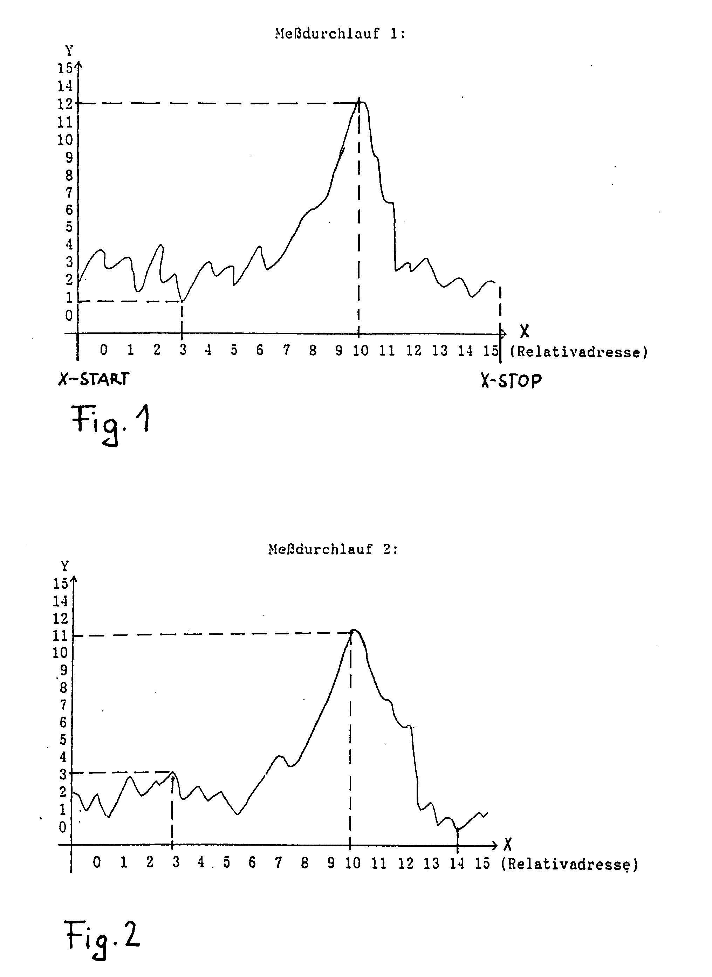

Der in Figur 1 dargestellte erste Meßdurchlauf enthalte in dem hier betrachteten Meßintervall an dem Teilintervall 3 einen Minimalwert MI1=1 (erster Wert) und an dem Teilintervall 10 einen Maximalwert MA1=10 (zweiter Wert). Diese Werte können in einem hier nicht dargestellten Speicher zusammen mit den Relativadressen AMI1=3 und AMA1=10 abgelegt werden.

Im zweiten Meßdurchlauf wird dann am Teilintervall 3, welches der Nummer der Relativadresse des vorher ermittelten Minimums entspricht, ein weiterer erster Wert MI2 gemessen, der mit dem vorherigen ersten Wert MI1 gemittelt wird, so daß ein neuer gemittelter erster Wert MI2av erhalten wird. Gleichzeitig wird beim zweiten Meßdurchlauf festgestellt, daß dort der Minimalwert bei dem Teilintervall 14 liegt, so daß daraus eine neue Relativadresse AMI2=14 für den nächsten Meßdurchlauf zur Messung des nächsten ersten Wertes festgehalten wird.

Beim zweiten Meßdurchlauf wird in gleicher Weise zur Mittelung des zweiten Wertes verfahren. Bei dem Teilintervall 10 wird entsprechend der beim ersten Meßdurchlauf festgehaltenen Relativadresse AMA1 der Wert MA2 = 11 gemessen, der mit dem zuvor ermittelten zweiten Wert MA1 aus dem ersten Meßdurchlauf gemittelt wird. Außerdem wird eine neue Relativadresse AMA2 für das Maximum festgehalten, und zwar AMA2 = 10, da dort beim zweiten Meßdurchlauf das Maximum liegt.

Im dritten Meßdurchlauf wird nun bei den festgehaltenen Relativadressen AMI2 = 14 und AMA2 = 10 gemessen und die festgestellten Werte zur Mittelwertbildung herangezogen. Außerdem wird eine neue Relativadresse anhand des dritten Meßdurchlaufs für den Minimalwert AMI3 = 6 festgehalten, da beim dritten Meßdurchlauf das Minimum bei dem Teilintervall 6 aufgetreten ist. Die Relativadresse für das Maximum ist AMA3 = 10, wie dies bereits bei den beiden vorhergehenden Meßdurchläufen der Fall war.

In einem vierten Meßdurchlauf kann dann nochmals an den zuvor festgelegten Relativadressen gemessen und eine Mittelwertbildung vorgenommen werden.

Nachfolgend wird die Messung, Mittelwertbildung und die Bestimmung der Relativadressen während der Meßdurchläufe 1 bis 4 nochmals in verkürzter Form dargestellt:

Figur 1: Erster Meßdurchlauf

Es wird angenommen, daß zunächst noch keine Relativadresse abgespeichert ist.
MI1 = 1 bei AMI1 = 3
MA1 = 12 bei AMA1 = 10

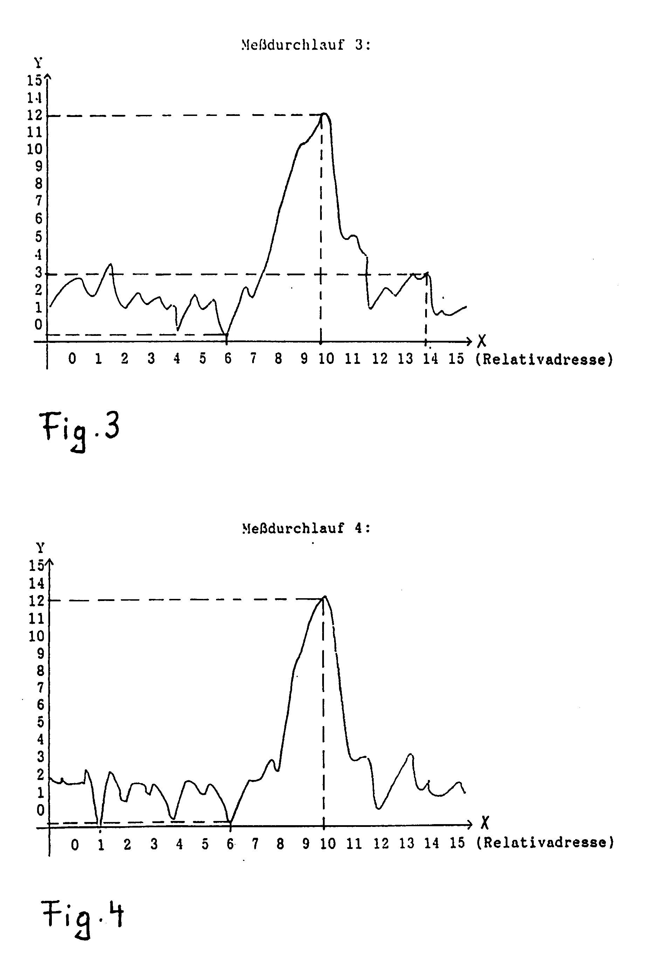

Figur 2: Zweiter Meßdurchlauf

Relativadressen AMI 1 = 3 und AMA 1 = 10 liegen vor.

Es wird somit zunächst an der Adresse für den Minimalwert ein weiterer erster Wert gemessen, also bei
AMI1 = 3 gemessen MI2 = 3
daraus ergibt sich der Mittelwert

$$MI2av = 1/2 \, (MI1 + MI2) = 2$$

Die Relativadresse für das Maximum war beim ersten Meßdurchlauf
AMA1 = 10, wo jetzt der neue zweite Wert MA2 = 11 beträgt. Daraus erhält man für den neuen Mittelwert des zweiten Wertes

$$MA2av = 1/2 \, (MA1 + MA2) = 11,5.$$

Als neue Relativadressen werden im zweiten Meßdurchlauf
für den Minimalwert AMI2 = 14
und für den
Maximalwert AMA2 = 10
festgestellt.

Figur 3: Dritter Meßdurchlauf

In gleicher Weise wie bei dem zweiten Meßdurchlauf erhält man hier folgende Werte: Bei
AMI2 = 14 ist MI3 = 3
bei AMA2 = 10 ist MA3 = 12
Für die Mittelwerte erhält man:

$$MI3av = 1/2 \, (MI2av + MI3) = 2,5$$

$$MA3av = 1/2 \, (MA2av + MA3) = 11,75$$

Als neue Relativadressen erhält man:

AMI3 = 6

AMA3 = 10

Figur 4: Vierter Meßdurchlauf

In entsprechender Weise wie bei dem dritten Meßdurchlauf erhält man hier die Mittelwerte:

$$MI4av = 1/2 \, (2,5 + MI4) = 1,25$$

$$MA4av = 1/2 \, (11,75 + MA4) = 11,875$$

Anstelle der hier beschriebenen arithmetischen Mittelwertbildung kann auch ein anderes bekanntes Verfahren zur Mittelwertbildung herangezogen werden.

**Patentansprüche**

1. Verfahren zur Mittelung und Verdichtung von Meßwerten für Meßgeräte, insbesondere Spektralanalysatoren, bei dem über einen in mehrere Meßintervalle unterteilten Meßbereich die Meßwerte (MI, MA) in Abhängigkeit von einer Meßgröße (0 bis 15) ermittelt werden und anschließend gemittelt und verdichtet werden, wobei in mehreren Meßdurchläufen aus den innerhalb eines Meßintervalls gemessenen Werten (MI, MA) ein erster Wert (MI1) an einer ersten Position (3) ausgewählt wird, **dadurch gekennzeichnet**, daß die Position (3) des ersten Werts (MI) beim ersten Meßdurchlauf vorgegeben und bei jedem weiteren Meßdurchlauf durch die Position (3, 14, 6) des Minimalwertes innerhalb desselben Meßintervalls beim davorliegenden Meßdurchlauf bestimmt ist, daß ein zweiter Wert (MA) an einer zweiten, beim ersten Meßdurchlauf vorgegebenen und bei jedem weiteren Meßdurchlauf durch die Position des Maximalwertes innerhalb desselben Meßintervalls beim davorliegenden Meßdurchlauf bestimmten Position ausgewählt wird, und daß einerseits die ersten Meßwerte (MI1, MI2) und andererseits die zweiten Meßwerte (MA1, MA2) derselben Meßintervalle von aufeinanderfolgenden Meßdurchläufen gemittelt werden und die dadurch erhaltenen Mittelwerte (MI2av) der ersten Meßwerte (MI1, MI2) mit ersten Meßwerten (MI3) und die dadurch erhaltenen Mittelwerte (MA2av) der zweiten Meßwerte (MA1, MA2) mit zweiten Meßwerten (MA3) desselben Meßintervalls wenigstens eines weiteren Meßdurchlaufs gemittelt werden.

2. Verfahren nach Anspruch 1, **dadurch gekennzeichnet**, daß innerhalb eines Meßintervalls beim ersten Meßdurchlauf als erster Meßwert (MI1) der Minimalwert und als zweiter Meßwert (MA1) der Maximalwert ausgewählt wird.

3. Verfahren nach einem der vorhergehenden Ansprüche, **dadurch gekennzeichnet**, daß die Meßintervalle in mehrere Teilintervalle (0 bis 15) unterteilt werden, wobei zu jedem Teilintervall (0 bis 15) genau ein Meßwert ermittelt wird, und daß die Position eines Meßwertes innerhalb eines Meßintervalls durch die Nummer des betreffenden Teilintervalls (0 bis 15) in Verbindung mit der Anzahl von Teilintervallen innerhalb des betreffenden Meßintervalls erfaßt wird.

4. Verfahren nach einem der Ansprüche 1 und 2, **dadurch gekennzeichnet**, daß alle Meßintervalle in eine gleiche Anzahl von Teilintervallen (0 bis 15) unterteilt werden, wobei zu jedem Teilintervall (0 bis 15) genau ein Meßwert ermittelt wird, und daß die Position eines Meßwertes innerhalb eines Meßintervalls nur durch die Nummer des betreffenden Teilintervalls (0 bis 15) erfaßt wird.

5. Verfahren nach einem der Ansprüche 3 und 4, **dadurch gekennzeichnet**, daß jedem Teilintervall (0 bis 15) innerhalb eines Meßintervalls genau ein Meßwert zugeordnet ist, der aus mehreren Einzelmeßwerten ermittelt wurde.

**Claims**

1. A method of averaging and compressing measured values for measuring instruments, especially spectral analyzers, whereby the measured values (MI, MA) are determined as a function of a measured quantity (0 to 15) over a measurement range that is subdivided into multiple measurement intervals, and then the measured values are averaged and compressed, whereby a first value (MI1) at a first position (3) is selected from the values (MI, MA) measured within a measurement interval in multiple measurement runs, characterized in that the position (3) of the first value (MI) in the first measurement run is predetermined, and with each additional measurement run, it is determined by the position (3, 14, 6) of the minimum value within the same measurement interval in the current measurement run; a second value (MA) is selected at a second position, which is predetermined in the first measurement run, and in each additional measurement run it is selected by the position of the maximum value within the same measurement interval in the current measurement run, and the first measured values (MI1, MI2) on the one hand and, on the other hand, the second measured values (MA1, MA2) of the same measurement intervals of successive measurement runs are averaged, and the resulting average values (MI2av) of the first measured values (MI1, MI2) are averaged with first measured values (MI3), and the resulting average values (MA2av) of the second measured values (MA1, MA2) are averaged with second measured values (MA3) of the same measurement interval of at least one additional measurement run.

2. A method according to Claim 1, characterized in that the minimum value is selected as the first measured value (MI1) within a measurement interval in the first measurement run, and the maximum value is selected as the second measured value (MA1).

3. A method according to one of the preceding claims, characterized in that the measurement intervals are subdivided into a plurality of part intervals (0 to 15), where exactly one measured value is determined for each part interval (0 to 15), and the position of a measured value within a measurement interval is determined by the number of the respective part interval (0 to 15) in combination with the number of part intervals within the respective measurement interval.

4. A method according to one of Claims 1 and 2, characterized in that all measurement intervals are subdivided into an equal number of part intervals (0 to 15), where exactly one measured value is determined for each part interval (0 to 15), and the position of a measured value within a measurement interval is determined only by the number of the respective part interval (0 to 15).

5. A method according to one of Claims 3 and 4, characterized in that exactly one measured value determined from multiple individual measured values is assigned to each part interval (0 to 15).

**Revendications**

1. Procédé de moyennage et de compression de valeurs mesurées pour des instruments de mesure, notamment des analyseurs de spectre, selon lequel, dans un champ de mesure divisé en plusieurs intervalles de mesure, les valeurs à mesurer (MI, MA) sont calculées en fonction d'une grandeur mesurée (0 à 15), puis amenées à une moyenne et comprimées, une première valeur (MI1) sur une première position (3) étant sélectionnée parmi les valeurs mesurées (MI, MA) à l'intérieur d'un intervalle de mesure, ce au cours de plusieurs opérations de mesure, caractérisé en ce que la position (3) de la première valeur (MI) est préréglée lors de la première opération de mesure puis définie au cours de chaque opération de mesure suivante en fonction de la position (3, 14, 6) qu'occupait la valeur minimale à l'intérieur du même intervalle de mesure lors de l'opération de mesure précédente, en ce qu'on sélectionne une seconde valeur (MA) sur une seconde position qui est préréglée pour la première opération de mesure et définie lors de chaque opération de mesure suivante en fonction de la position qu'occupait la valeur maximale à l'intérieur du même intervalle de mesure lors de l'opération de mesure précédente et en ce qu'on calcule la moyenne des premières valeurs mesurées (MI1, MI2) d'une part et des secondes valeurs mesurées (MA1, MA2) d'autre part relevées dans les mêmes intervalles de mesure lors d'opérations de mesure successives et fait la moyenne des valeurs moyennes (MI2av) ainsi obtenues correspondant aux premières valeurs mesurées (MI1, MI2) avec des premières valeurs mesurées (MI3) et la moyenne des valeurs moyennes (MA2av) ainsi obtenues correspondant aux secondes valeurs mesurées (MA1, MA2) avec des secondes valeurs (MA3) mesurées dans un même intervalle de mesure lors d'au moins une autre opération de mesure.

2. Procédé selon la revendication 1 caractérisé en ce qu'à l'intérieur d'un intervalle de mesure et lors de la première opération de mesure, on sélectionne la valeur minimale comme première valeur mesurée (MI1) et la valeur maximale comme seconde valeur mesurée (MA1).

3. Procédé selon l'une des revendications précédentes caractérisé en ce que les intervalles de mesure sont subdivisés en une pluralité de sous-intervalles (0 à 15), une valeur de mesure exactement étant calculée pour chaque sous-intervalle (0 à 15) et en ce que la position d'une valeur mesurée à l'intérieur d'un intervalle de mesure est décelée au moyen du numéro du sous-intervalle concerné (0 à 15) combiné au nombre de sous-intervalles se trouvant à l'intérieur de l'intervalle de mesure concerné.

4. Procédé selon l'une des revendications 1 et 2 caractérisé en ce que tous les intervalles de mesure sont subdivisés en un nombre égal de sous-intervalles (0 à 15), une valeur de mesure exactement étant calculée pour chaque sous-intervalle (0 à 15) et en ce que la position d'une valeur mesurée à l'intérieur d'un intervalle de mesure n'est décelée qu'au moyen du numéro du sous-intervalle concerné (0 à 15).

5. Procédé selon l'une des revendications 3 et 4 caractérisé en ce qu'à chaque sous-intervalle (0 à 15) se trouvant à l'intérieur d'un intervalle de mesure, on a attribué une valeur de mesure exactement qui a été calculée à partir de plusieurs valeurs mesurées individuelles.

Meßdurchlauf 1:

Fig. 1

Meßdurchlauf 2:

Fig. 2

Meßdurchlauf 3:

**Fig.3**

Meßdurchlauf 4:

**Fig.4**